# EUROPEAN PATENT APPLICATION

(11) **EP 2 337 439 A1**
(43) Date of publication of application: **22.06.2011**
(21) Application number: 09179230.9
(22) Date of filing: 15.12.2009
(51) Int. Cl.: H05K 9/00

(54) **Protection of a civil construction from an electromagnetic pulse**

(71) Applicant: SIEMENS AKTIENGESELLSCHAFT, 80333 München (DE)
(72) Inventor: Menrath, Raimund, 96135, Mühlendorf (DE); Trossen, Manfred, 91325, Adelsdorf (DE); Will, Emanuel, 96146, Altendorf (DE)

(57) **Abstract**

In accordance with the present invention, a method for protecting a civil construction from an electromagnetic pulse comprises installing an electromagnetic pulse shielding layer (2) on each surface (1) of a plurality of surfaces that form said construction. The installation comprises applying a coating (3) of an electrically insulative material on said surface (1) and installing one or more layers (4, 6) of an electrically conductive mesh fabric upon said coating (3). The one or more layers (4, 6) of said fabric are separated by an embedding coating (5) of said electrically insulative material. The method further includes establishing an electrically conductive connection establishing an electrically conductive connection between the installed shielding layers (2) on adjoining surfaces of said construction, to form a continuous electrically conductive screen around said construction that is impenetrable for an electromagnetic pulse.

## Description

The present invention relates to protection of a civil construction from the action of external electromagnetic influences such as an electromagnetic pulse (EMP) attack. Such an EMP may comprise, for example high-altitude electromagnetic pulse (HEMP) and high power electromagnetic (HPEM) pulse, among others.

An electromagnetic pulse (EMP) is a burst of electromagnetic radiation from an explosion (especially a nuclear explosion) or a suddenly fluctuating magnetic field. The resulting electric and magnetic fields may couple with electrical/electronic systems to produce damaging current and voltage surges. EMP includes, for example, high-altitude electromagnetic pulse (HEMP) and high power electromagnetic (HPEM) pulse, among others.

A Faraday cage, named after the English scientist Michael Faraday who invented the same, is known to be an enclosure formed by conducting material that blocks out external static electrical fields and electromagnetic radiation. The operation of a Faraday cage depends on the fact that an external static electrical field will cause the electrical charges within the conducting material of the cage to redistribute themselves so as to cancel the field's effects in the cage's interior. This phenomenon is used, for example, to protect electrical and electronic equipment from lightning strikes and other electrostatic discharges.

However, there is no known technique for protection of an entire civil construction from an EMP attack.

The object of the present invention is to provide a technical solution for protection of an entire civil construction from an electromagnetic pulse.

The above object is achieved by the method according to claim 1.

The underlying idea of the present invention is to protect an entire civil construction from an EMP pulse based on the principle of the "Faraday cage" using an EMP screening mesh fabric made of an electrically conductive material. To that end, an EMP shielding layer is installed on all surfaces of the construction by installing one or more layers of said fabric embedded with electrically insulative material, which also provide protection from corrosion. Electrically conductive connections are established between the shielding layers installed on all these surfaces, to effect a Faraday cage around the construction. The present invention may be advantageously used for EMP protection of civil constructions where safety from EMP attacks is critical.

In one embodiment, in order to form a continuous shielding layer each layer of said fabric is installed by installing multiple runs of said fabric adjacently, and forming an electrically conductive seam to couple adjacent runs of said fabric.

In a further embodiment, in order to obtain an effective electrically conductive seam, forming said seam comprises:
- folding respective adjoining edges of said adjacent runs of the fabric,
- interlocking respective folds of said adjacent runs and clamping them at a predefined distance from said edges, and
- pressing said fabric to embed said fabric into the coating of said electrically insulative material and applying a further coating of said electrically insulative material over said seam.

In a preferred embodiment, for protection from very high frequency EMP pulse (of the order of 3GHz), said fabric comprises a copper mesh having a rectangular mesh size equal to or less than 0.4mm X 0.4mm.

In an exemplary embodiment, said electrically insulative material comprises bitumen or plaster, to provide increased mechanical support to the mesh fabric.

In one embodiment, said plurality of surfaces are concrete surfaces including one or more surfaces on a foundation of said construction, one or more surfaces on walls below ground level, one or more surfaces on walls or ceilings above ground level and one or more surfaces on a roof of said construction. In this complete shielding of the construction is provided to effect a Faraday cage around said construction.

In one embodiment, wherein the construction includes adjoining first and second surfaces, wherein said establishing of an electrically conductive connection between the installed shielding layers on said adjoining first and second surfaces comprises electrically conductively coupling said adjacently installed shielding layers using an anchor rail fixed to said first surface. Electrically conductive connections can thus be established between the shielding layers installed adjoining surfaces, for example the foundation and the walls of the construction in contact with the foundation.

In an exemplary further embodiment, said electrically conductive coupling using said anchor rail further comprises:
- disposing a first metal plate over said anchor rail through one or more bolts that are fixed to said anchor rail,
- carrying the layers of said electrically conductive mesh fabric on said first surface and said second surface over said one or more bolts to form an overlap between said layers, said layers of the fabric being penetrated by the bolts,

- disposing a metallic spring over said overlapping layers of fabric though said one or more bolts, and
- disposing a second metal plate over said metallic spring through said bolts. The above arrangement makes use of the overlap to establish an electrically conductive connection between the shielding layers on the two surfaces. Furthermore, contact corrosion is avoided by use of the metallic spring.

In another embodiment, said surface has an anchor bolt penetrated therethrough for installing a further mounting part of said construction thereto, said method further comprising permanently fastening a first washer with an inner thread around said anchor bolt before installing said shielding layer on said surface and permanently fastening a second washer with an inner thread around said anchor bolt after said installation of said shielding layer, wherein said electrically conductive mesh fabric of said shielding layer is penetrated by said anchor bolt and said coatings of said electrically insulative material are applied maintaining a clearance area around said anchor bolt corresponding to the surface of said washer. Thus, an electrically conductive connection is established between the anchor bolt and the shielding layer, allowing the further mounting parts to be subsequently installed on the second washer.

In an exemplary embodiment, to obtain an effective connection of the shielding layer to the anchor bolt while avoiding contamination of the anchor bolt and the washers, the proposed method further comprises:
- applying a first coating of said electrically insulative material over said surface after fastening said first washer around said anchor bolt,
- installing a first layer of the electrically conductive mesh fabric over said first coating, said fabric being penetrated by said anchor bolt,
- temporarily fastening the second washer around said anchor bolt,
- applying a second coating of said electrically insulative material over the first layer of said fabric,
- removing the temporarily fastened second washer and installing a second layer of said fabric over said second coating, said second layer of the fabric penetrated by said anchor bolt,
- applying a third coating of said electrically insulative material over said second layer of said fabric, said third coating maintaining a clearance area around said anchor bolt corresponding to the surface of said washer, and
- permanently fastening said second washer around said anchor bolt.

The present invention may also be used for electrically conductively connecting the shielding layer to water draining gullies on the roof. Accordingly, in one embodiment, the method further comprises:
- installing a roof gully on said surface by fixing a flanged base of said roof gully to said surface,
- installing said shielding layer wherein the coatings of said electrically insulative material are applied over said surface around said roof gully and maintaining a predefined clearance from the area directly above the installation of said roof gully, and
- electrically conductively connecting said roof gully to said shielding layer using one or more layers of sealing wires disposed circumferentially around a circumferential row of bolts fixed to said flanged base, the ends of each wire further being electrically conductively connected.

In order to achieve an effective electrical connection between the roof gully and the shielding layer, the proposed method further comprises
- installing the roof gully on said surface after the application of a first coating of said electrically insulative material on said surface,
- installing a first layer one or more of electrically conductive sealing wires supported circumferentially around said bolts,
- installing first and second layers of the electrically conductive mesh fabric upon said sealing wires, said first and second layers of the fabric being penetrated by said bolts and separated by said embedding coatings over said surface around said roof gully and interspaced by said sealing wires directly the installation of said roof gully,
- installing a second layer of one or more electrically conductive sealing wires over said second layer of said mesh fabric and circumferentially supported around said bolts, and
- fastening an outer flange to said bolts over said second layer of sealing wires.

In order to protect the connection of the shielding layer with the roof gully from lightning, in a further embodiment, the proposed method further comprises installing layer of a lightning protection material around said roof gully, said lightning protection layer being installed before the installation of said roof gully and being electrically conductively connected to said roof gully

The present invention can also be used for EMP protection on joints between surfaces that are thermally expandable and can thus be used in a wide range of temperatures, for example - 30° C to 40° C. Accordingly, in one embodiment, the construction comprises first and second surfaces adjoining each other along an expandable joint, wherein the one or more layers of the electrically conductive mesh fabric are installed over said surfaces and also covering said joint and the coatings of said electrically insulative material are applied over said surfaces and maintaining a pre-defined clearance from said joint, the method further comprising installing one or more layers of an electrically insulative elastic membrane covering said joint such that the one or more layers of said fabric are separated by said one or more layers of the elastic membrane over said joint.

In order to establish an effective electrical connection at the joint, in an exemplary embodiment, the proposed method further comprises:
- installing a first layer of the elastic membrane over said surfaces and covering said joint,
- applying a first coating of said electrically insulative material over said surfaces and maintaining a predefined clearance from said joint, and installing a first layer of the electrically conductive mesh fabric thereon and covering said joint,
- installing a second layer of the elastic membrane upon the first layer of said fabric and covering said joint, and
- applying a second coating of said insulative material over said first layer of said fabric maintaining a predefined clearance from said joint and installing the second layer of said fabric thereon and covering said joint.

To provide mechanical support to the elastic membranes, in one embodiment, installing each of the layers of the elastic membrane further comprises applying a coating of a bitumen primer and adhesively fixing said each layer of the elastic membrane the already applied primer

In a further embodiment, to provide water proofing to the connection, particularly for joints below ground level, the proposed method further includes installing a layer of a polymer bitumen welding sheet over said second layer of said fabric over said surfaces and maintaining a predefined clearance from said joint, and further installing a layer of an elastic water proofing membrane over said welding sheet and covering said joint.

To provide mechanical support to the joint, in a further embodiment, the proposed method further includes further installing one or more thermal insulation boards over said elastic water proofing membrane.

In a still further embodiment, to provide protection of the connection of the shielding layer at the joint from lightning, the proposed method further includes installing a lightning protection layer over said joint before installing said layers of elastic membranes.

In an exemplary embodiment, said first and second surfaces are parallel to each other. In an alternate embodiment, said first and second surfaces are perpendicular to each other. The proposed method can thus be used for joints between horizontal even surfaces as well as joints between vertical and horizontal surfaces of the construction.

Still further, the present invention can also be used for establishing electrical connections of the shielding layer when the surface has penetrations such as pipe culverts. Accordingly, in one embodiment, the surface has a pipe penetrated therethrough, said method further comprising
- installing said shielding layer on said surface around said pipe,
- disposing a metallic sleeve around said pipe,
- disposing a metallic plate on said surface around said pipe, said metallic plate being further welded to said metallic sleeve, and
- electrically conductively connecting said shielding layer to said metallic plate.

The present invention is further described hereinafter with reference to illustrated embodiments shown in the accompanying drawings, in which:
FIG 1 is a flowchart illustrating an exemplary installation method for EMP protection of a civil construction inc accordance with one embodiment of the present invention,
FIG 2 is a cross-sectional view illustrating a shielding layer installed on a surface of the construction,
FIG 3 is a cross-sectional view illustrating an EMP shield connection involving an anchor rail,
FIG 4 is a cross-sectional view illustrating an EMP shield connection on an expandable joint between horizontal even surfaces,
FIG 5 is a cross-sectional view illustrating an EMP shield connection on an expandable joint between horizontal and vertical surfaces,
FIG 6 is a cross-sectional view illustrating an EMP shield connection to an anchor bolt,
FIG 7 is a cross-sectional view illustrating an EMP shield connection to a roof gully,
FIG 8 is a plan view of the roof gully, and
FIG 9 is a cross-sectional view illustrating an EMP shield connection to a pipe culvert.

Embodiments of the present invention described below provide a technique to protect an entire civil construction from an EMP pulse based on the principle of the "Faraday cage" using an EMP screening fabric made of an electrically conductive material. To that end, an EMP shielding layer is installed on all surfaces of the construction by installing one or more layers of an electrically conductive mesh fabric (also referred to as an EMP screening fabric) embedded with an electrically insulative material, that also provide protection from corrosion. Electrically conductive connections are established between the shielding layers installed on all these surfaces, to effect a Faraday cage around the construction.

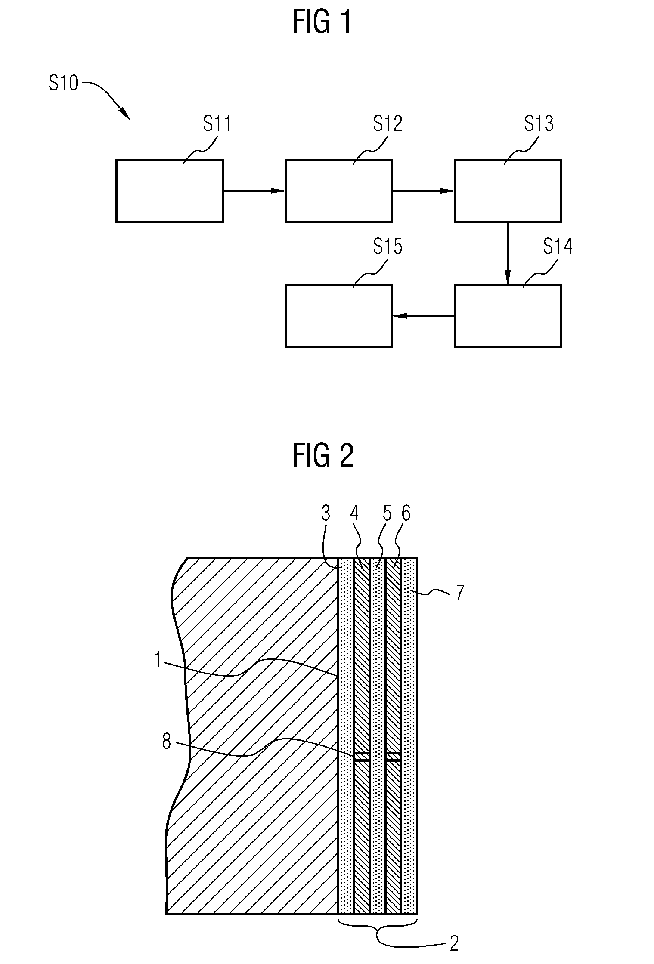

FIG 1 illustrates an installation method S10 for protecting a civil construction from an electromagnetic pulse in accordance with one embodiment of the present invention. The method S10 begins at block S11 by preparing the surface of construction to be shielded. This may include cleaning and measuring the installation area of the surface. The surface and the shielding materials are preferably maintained at a temperature of at least 5° C. Next at block S12, a shielding layer is installed on to the surface as illustrated referring to FIG 2. FIG 2 is a cross-sectional view illustrating a shielding layer 2 installed on a surface 1 of the construction. The surface 1 may include any surface of the construction, for example, on the foundation, on walls below ground level, on walls and ceilings above ground level, on the roof, and so on. The surface 1 can accordingly be a vertical or a horizontal surface.

Installation of the shielding layer 2 includes a uniform application of a coating 3 of an embedding material, which is electrically insulative, over the surface 1. The embedding material can include, for example plaster, or bitumen. On the coating 3, the first layer 4 of the EMP screening fabric is installed. The EMP screening fabric is a mesh made of an electrically conductive material, for example copper. For shielding against EMP, the mesh size should be sufficiently small with respect to the wavelength of the EMP. In a preferred embodiment, the EMP screening fabric comprises a copper mesh having rectangular mesh size less than or equal to 0.4mm X 0.4mm, which advantageously provides shielding even against very high frequency (i.e., low wavelength) electromagnetic pulse, for example having a frequency of the order of 3GHz. The mesh fabric is supplied on rolls to the installation site, each roll having a fixed run length, which may be for example, several meters. The layer 4 of the mesh fabric is disposed on the coating 3 by placing the fabric roll on one edge of the coated surface and rolling out and pressing the fabric on to the coating 3. The edges of each run of fabric are folded and the fold is opened at an angle, for example from 45-90 degrees in preparation for the next run of the fabric. The individual runs of mesh of the layer 4 may be connected by an electrically conductive seam 8 prepared on site. This is done, for example by interlocking the respective folds of adjacent runs and clamping then at a predetermined distance, for example 50-100 mm from the edges (maximum) and then smoothing out. The seam is then again pressed firmly into the embedding coating 3, for example using a trowel and an area, for example, up to 100 mm before the fell seam, is filled in with the embedding material and completely covered with the embedding material. The entire surface to be processed is then covered with a second coating 5 of the embedding material till the mesh fabric is no longer visible. Following a drying time, which may be determined locally, a second layer 6 of mesh and a third coating 7 may be worked in the same way. The coating 5 of the embedding material is applied to maintain a minimum distance, for example about 2mm, between the layers 4 and 6 of the mesh fabric. Suitable construction measures (for example, covering) may be used to protect the coated surface from the effects of or loading by water, frost or sun during the drying time.

Referring back to FIG 1, block S12 includes installing such a shielding layer on each surface of the construction, including, as mentioned before, the foundation, walls and ceilings above and below ground level, roof and so on. Next at block S13, electrically conductive connections are established between the shielding layers on each pair of adjoining surfaces of the construction, to form a continuous electrically conductive EMP screen around the construction that effects a Faraday cage around the construction that is impenetrable for an electromagnetic pulse.

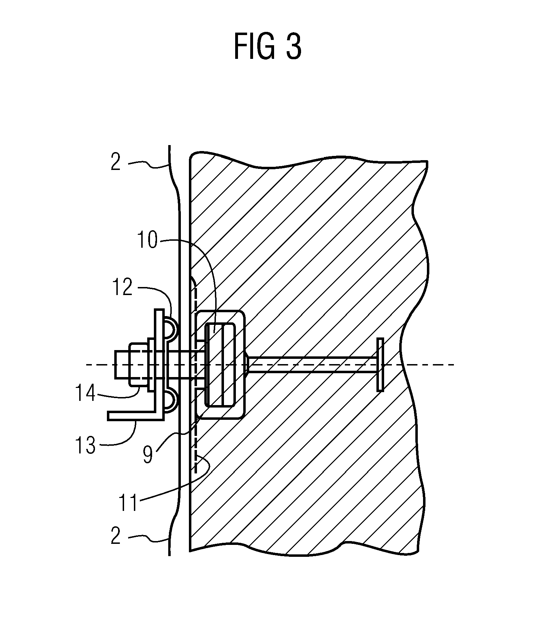

In one embodiment of the present invention illustrated in FIG 3, the installed shielding layers on adjoining surfaces of the construction, for example a surface on the foundation and a surface on a wall below ground level adjoining the foundation surface, are electrically conductively coupled using an anchor rail 9, including, for example, a Halfen^{™} rail. FIG 3 illustrates a cross sectional view of the exemplary anchor rail 9, which has a C-shaped cross sectional profile. The anchor rail 9 may be fixed to the foundation surface. A plurality of longitudinally spaced bolts 10 (also referred to as T-bolts) are fixed to the anchor rail 9. After positioning of the T-bolts 10 on the anchor rail 9, a first metal plate, for example a copper web 11 is disposed on the rail 9 through the T-bolts 10. The spacing between the T-bolts 10 may be predetermined by the position of holes on the copper plate 11. The embedding material is coated above and below the anchor rail 9 but not on the anchor rail 9. The layers of the mesh fabric from shielding layers 2 on the surfaces (installed as discussed above) above and below the anchor rail 9 are carried over the T-bolts 10 to form an overlap between said mesh fabric layers, the overlapping layers of the mesh fabric being penetrated by the T-bolts 10. Subsequently, a metallic spring 12, for example, made of copper or beryllium is disposed over the overlapping layers of fabric through the T-bolts 10. The copper or beryllium spring 12 is used to reduce contact corrosion. Next, a second metal plate, for example a stainless steel plate 13 having an L-shaped cross-sectional profile is disposed the metallic spring 12 through the bolts 10, and the bolts 10 are fixed with nuts 14. The above-described installation establishes an electrically conductive connection between EMP shielding layers 2 on the surfaces above and below the anchor rail 9 (i.e., the foundation surface and the wall in contact with the foundation surface, in this example). In one embodiment, the anchor rail 9 may connect the EMP shielding layer to the earthing grid on the foundation.

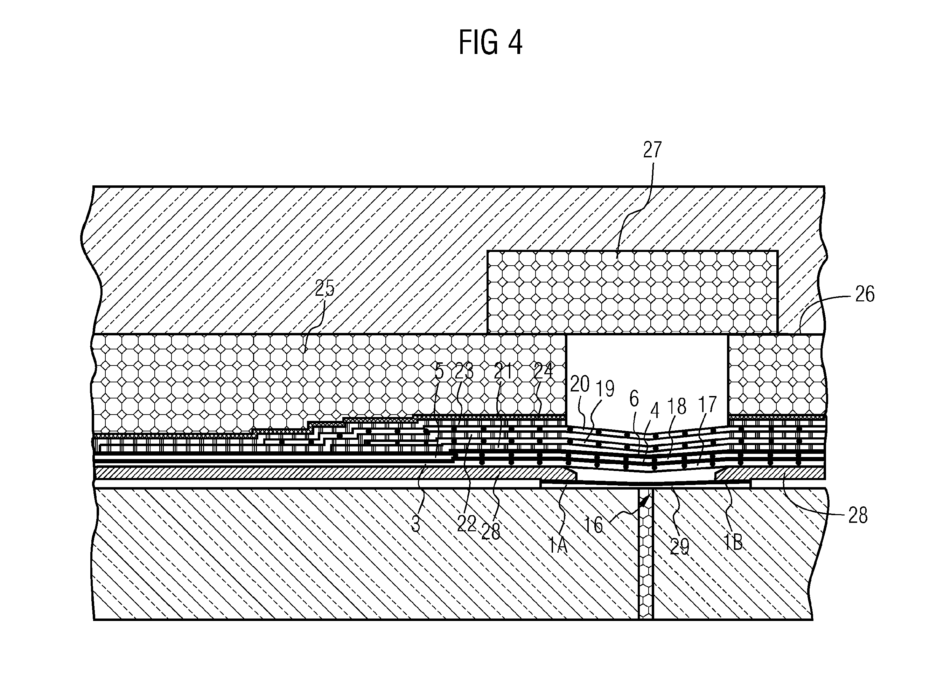

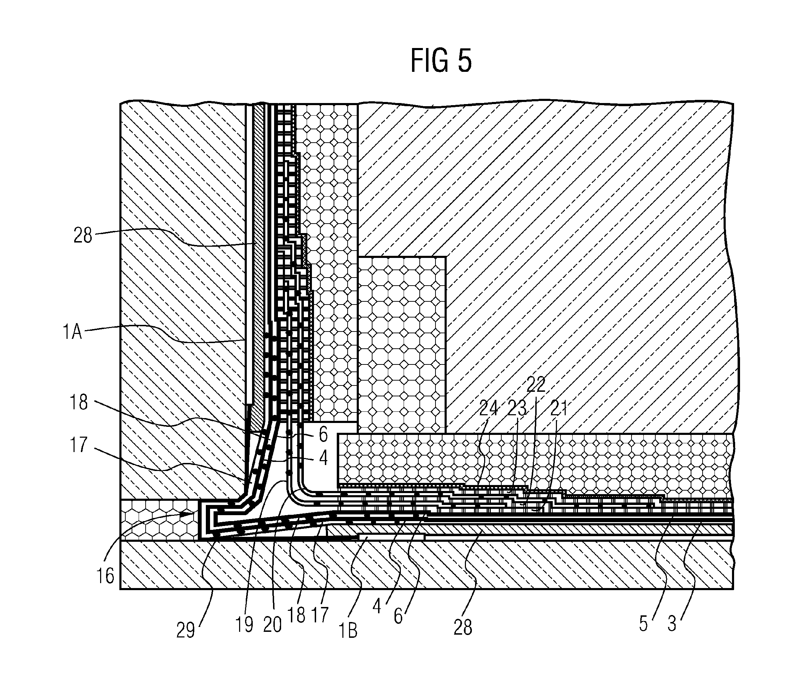

In some cases, particularly in locations having high ranges of temperature, joints between adjoining surfaces of the construction may be prone to thermal expansion. In such cases, the shielding layers of such adjoining surfaces may be connected as illustrated below referring to FIGS 4 and 5. The method proposed herein may be used for joints between parallel surfaces or joints at the corner between a vertical and a horizontal surface. In FIG 4, the adjoining surfaces 1A and 1B are horizontal and parallel surfaces while in FIG 5, the surface 1A is vertical and the adjoining surface 1B is horizontal. Referring jointly to FIG 4 and 5, for such expandable joints 16, the proposed method involves the use of one or more layers of an electrically insulative elastic membrane over the joint. In this example, first and second layers 17 and 18 of the elastic membrane are installed covering the joint. The layers 17 and 18 of elastic membranes may be include pre-cut elastic blanks and may be installed by first applying a coating of a primer such as bitumen on the surface and adhesively fixing the elastic membrane layer on the primer. The mesh fabric layers 4 and 6 are installed covering the joint 16 but the first and second coatings 3 and 5 of the embedding material are applied on the surfaces 1A and 1B but maintaining a predefined clearance from the joint 16 as shown, such that the mesh layers 4 and 6 are interspaced by the elastic membranes 17 and 18 over the joint 16. Optionally, a water-proofing layer be further installed, which is useful for joints below ground level. For this, one or more layers 19 and 20 of an elastic water-proofing membrane are disposed over the mesh fabric layer 6, the layers 19 and 20 being further separated by layers 21, 22 and 23 of a welding sheet, for example, made of a polymer bitumen, that are installed over the surfaces but not over the area directly above the joint 16. The water proofing elastic membranes 19 and 20 may be installed using a bitumen primer as described before. A further covering layer 24 made of plaster may be further disposed over the last welding sheet 23. Thereon, mechanical protection or thermal insulation boards 25, 25 and 27 may be installed successive with gravel back filing. In the shown example, the boards 25 and 26 are installed directly above the surfaces 1A and 1B and the gap between the boards 25 and 26 is bridged by the board 27.

The above described installation provides a robust electrical connection at thermally expandable joints and may hence be used in a wide range of temperatures. In a further embodiment, a lightning protection layer 28 may be installed on the surfaces 1A and 1B prior to installation of the EMP shielding layer on the joint. The layer 28 may be welded to a copper wire 29 disposed on the joint 16 and may comprise, for example, plaster, concrete, screed , among others.

Certain surfaces of the construction may include penetrations such as anchor bolts, roof gullies, pipe culverts, among others. Referring back to FIG 1, block S14 of the proposed method S10 includes electrically connecting the shielding layer to such connections. Embodiments of the present invention described below illustrate the installation of the shielding layers on surfaces having the above-mentioned penetrations.

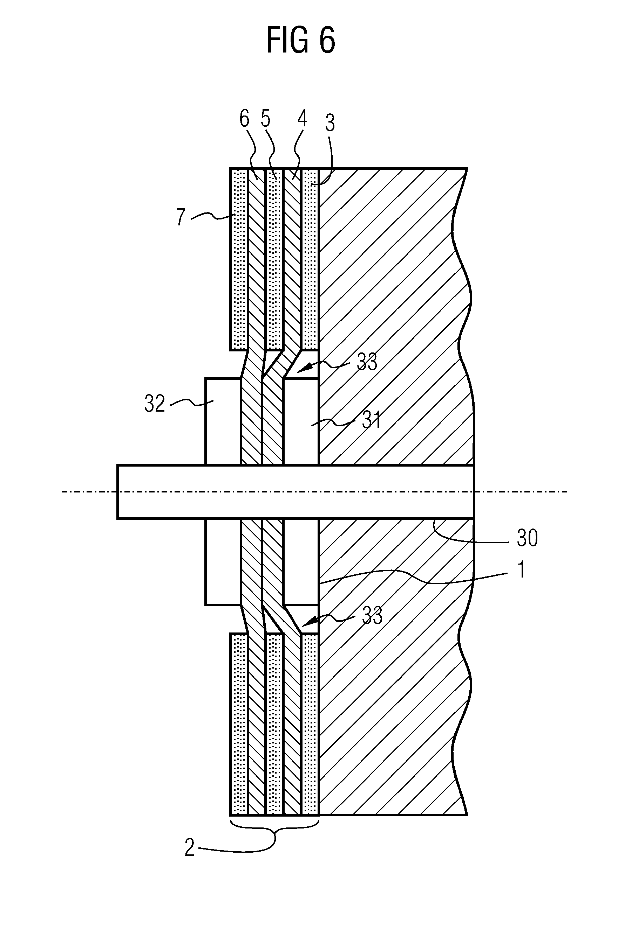

FIG 6 shows a cross-sectional view of an anchor bolt 30 penetrated through a surface 1 of the construction, which may be used, for example, for installing further mounting parts of the construction. In accordance with the proposed technique, an electrical connection is established with the anchor bolt by permanently fastening a first washer 31 having an inner thread around the anchor bolt 30 before installing the EMP shielding layer 2 and permanently fastening a second washer 32 having an inner thread around the anchor bolt 30 after installing the shielding layer 2. The washers 31 and 32 may be made, for example, of stainless steel. The installation method begins by fastening the first washer 31 with inner thread permanently around the anchor bolt 30. The first coating 3 of the embedding material (for example, plaster) is then applied on the surface 1 but maintaining a predefined clearance 33 (exaggerated in FIG 6) from the projection surface of the washer 30. During the application of the coating, the anchor bolt 30 and the washer 31 are protected from contamination. The first layer 4 of the mesh fabric is then installed on the layer 3 of the embedding material and penetrated by the anchor bolt 3. To that end, the mesh fabric may be pre-penetrated at the location of the anchor bolt using a sharp piercing tool. To avoid any contaminations of the mesh by the embedding material around the anchor bolt areas, the second washer 32 is temporarily or loosely fastened around the anchor bolt 30. While the second washer 32 is temporarily fastened, a second coating 5 of the embedding material is applied. The second washer 32 is then removed and a second layer 6 of the mesh fabric is installed over the coating 5. The second washer 32 is then permanently fastened around the anchor bolt 30. To avoid damages during the fastening of the second washer with an inner thread caused by the moment of force, a rectangular decoupling torque stainless steel sheet may be used having a hole thereon, the size of which depends on the diameter of the anchor bolt. During the fastening process of the second washer with an inner thread, the decoupling torque sheet is held by pliers or an equivalent tool. After permanent fastening of the second washer 32, the bent-up edge where the decoupling torque sheet was held is bent back and afterwards covered by a third coating 7 of the embedding material. The coatings 3, 5 and 7 are applied preferably with a thickness of around 2mm, maintaining a clearance from the area corresponding to the projection area of the washers. During the application of the coating, the anchor bolt 30 and the washers 31 and 32 may be protected from contamination by the embedding material. The above installation provides an effective connection of the shielding layer to the anchor bolt while avoiding contamination of the anchor bolt and the washers. Further mounting parts of the construction may be subsequently installed over the second washer 32. Advantageously, in a further embodiment, a lightning/earthing protection layer (not shown) for example, located below plaster, concrete, screed or equivalent may be installed on the surface 1 prior to installation of the EMP shielding layer 2.

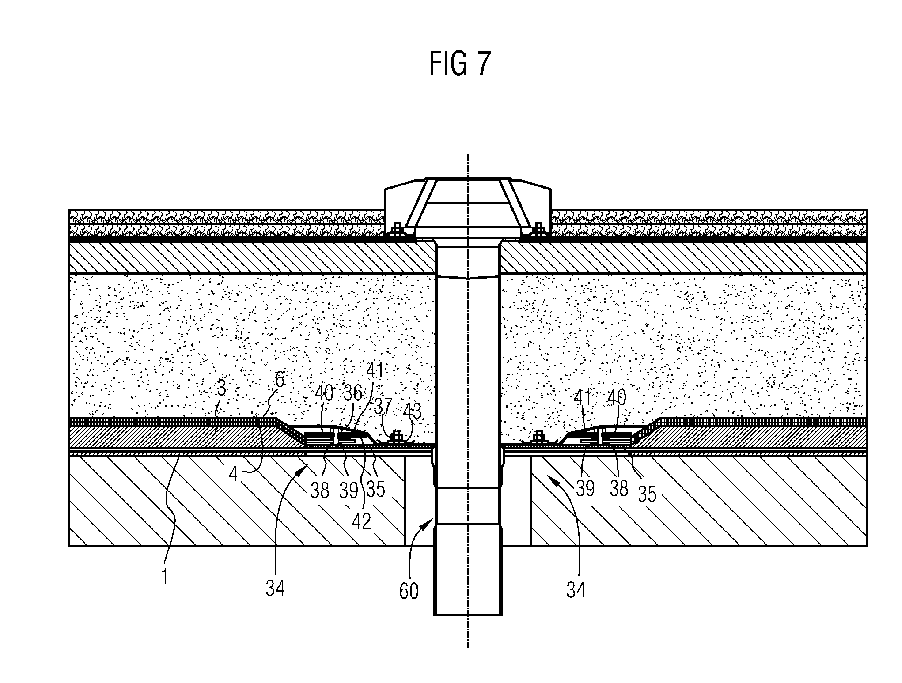

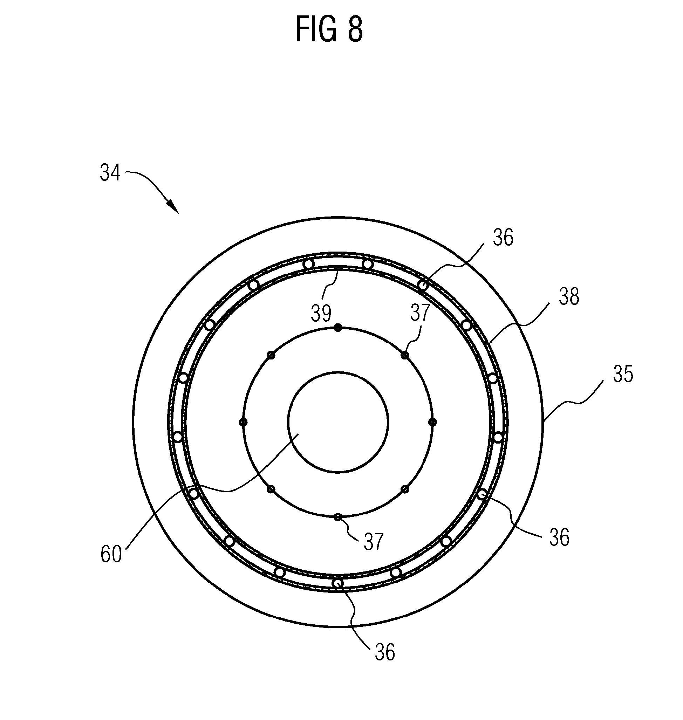

Referring to FIG 7 is shown a cross-sectional view of an EMP shield connection to a roof gully 34 in accordance with one embodiment of the present invention. The plan view of the roof gully 34 is shown in FIG 8. Referring jointly to FIGS 7 and 8, the roof gully 34 has a flanged base 35 (also referred to as "fixed flange"), for example, made of stainless steel, upon which is welded an outer circumferential row of bolts 36 and optionally, an inner circumferential row of bolts 37. The roof gully 34 is mounted on a surface 1 at the opening of a drain water pipe 60. The installation begins by mounting the roof gully 34 on a layer 3 of embedding material, for example of plaster, screed, concrete or equivalent. The gully 34 is leveled in the embedding material. The gully 34 is installed by fixing the fixed flange 35 to the surface 1. Subsequently, a first layer of sealing wires 38 and 39 are disposed around the outer row of bolts 36, on either said of the row of bolts 36 as illustrated in FIG 8. The sealing wires 38 and 39 are made, for example, of copper, and are continuously installed without any gaps. The ends of each of the wires 38 and 39 are electrically conductively connected. This can be achieving by an adhesive copper strip with special electrically conductive glue. Both sealing wires are maintained straight to the bolts and to flanged base 35 without buckles. The first layer 4 of the mesh fabric is then installed to the gully separate to the surface installation. The fabric is penetrated by the bolts 36, for which purpose, the fabric may be pre-penetrated thin sharp round tool, which is smaller in diameter size than the bolts 36. Subsequent to installation of the mesh layer 4, an intermediate layer 5 of the embedding material is installed maintaining a predefined clearance from the mounting area of the roof gully 34. That is, no intermediate layer is installed in the direct location above the mounting area of the roof gully 34. Next, a second layer 6 of mesh fabric is installed similar to the first layer 4, after which a second layer of sealing wires 40 and 41 are installed in a similar manner as the first layer of sealing wires 38 and 39. The mesh fabric is connected to the sealing wires by a clamp collar 42.

Above the installed second layer of the sealing rings 40 and 41, an outer loose flange 43 is fixed. The loose flange 43 is mounted in a manner so that the sealing wires below it do not shift. After fixing of the loose flange, the two mesh layers 4 and 6 may be cut above the drain pipe opening. Subsequently, further non EMP related layers like a vapour membrane 44 is installed. In the illustrated example, the vapour membrane 44 is fastened to the inner row of bolts 37. Although not specifically illustrated, a layer of a lightning protection material may be advantageously installed around the roof gully before the installation of the roof gully, which may be further electrically conductively connected to the roof gully, for example, by steel bars installed below the roof gully.

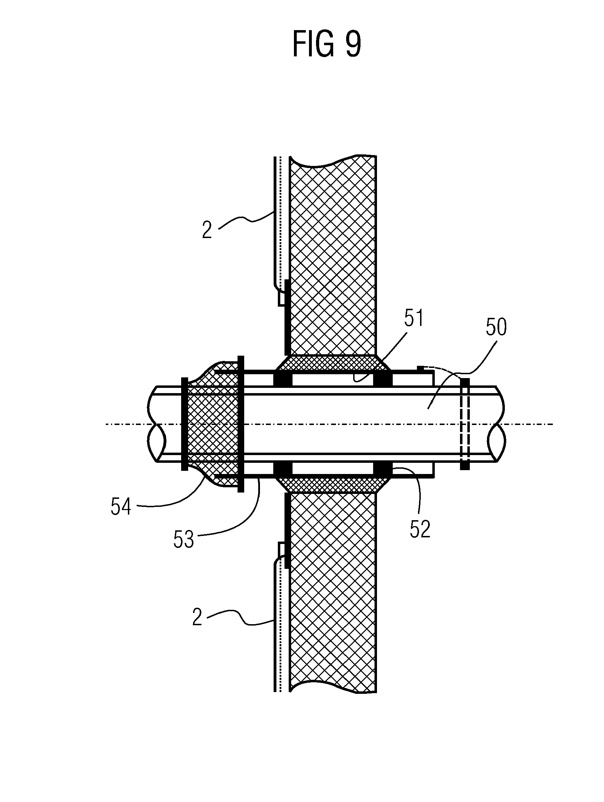

FIG 9 is a cross-sectional view of a pipe 50 penetrated through a surface 1. In the illustrated embodiment, the shielding layer 2 is disposed on the surface 1 around the pipe 50. For establishing an electrically conductive connection with the shielding layer 2, a metallic sleeve 51 is disposed around the pipe 50 penetrating through the surface 1 and further mounted on a special protective reinforced compensator 54 fixed to the pipe 50. One or more electrically insulative, heat or fire protective, sealing members 52 may be disposed between the pipe 50 and the sleeve 51. A metallic plate 53 is disposed on the surface 1, being further welded to the sleeve 1. The EMP shielding layer 2 electrically conductively coupled to the metallic plate 53 to complete the installation.

Referring back to FIG 1, block S15 of the method includes repairing any damage to the mesh fabric. The resulting holes in the mesh fabric during installations where the fabric has been penetrated may also be treated as a repair area. In an exemplary embodiment, if the dimension of damage is below or up to 150 mm and the location is below ground level, the repair section of the mesh shall is made to overlap, for example by 200 mm all around the outer edge of the damaged area. The mesh section may be stapled to the outer edge area using stainless steel staples at intervals, for example, not exceeding 30mm and then covered by a coating of the embedding material. If the dimension of the damage is much higher (e.g. > 150 mm), if the location is above ground level, the whole area with damages of the mesh may be repaired with a renewed shielding arrangement using the mesh runs electrically conductively connected with seam together with the remaining mesh and embedding materials. The remaining mesh fabric may be accordingly cleaned and prepared for such connections.

Summarizing, a method for protecting a civil construction from an electromagnetic pulse in accordance with the present invention comprises installing an electromagnetic pulse shielding layer on each surface of a plurality of surfaces that form said construction. The installation comprises applying a coating of an electrically insulative material on said surface and installing one or more layers of an electrically conductive mesh fabric upon said coating. The one or more layers of said fabric are separated by an embedding coating of said electrically insulative material. The method further includes establishing an electrically conductive connection establishing an electrically conductive connection between the installed shielding layers on adjoining surfaces of said construction, to form a continuous electrically conductive screen around said construction that is impenetrable for an electromagnetic pulse.

Although the invention has been described with reference to specific embodiments, this description is not meant to be construed in a limiting sense. Various modifications of the disclosed embodiments, as well as alternate embodiments of the invention, will become apparent to persons skilled in the art upon reference to the description of the invention. It is therefore contemplated that such modifications can be made without departing from the spirit or scope of the present invention as defined by the below-mentioned patent claims.

## Claims

1. A method for protecting a civil construction from an electromagnetic pulse, comprising:
- installing an electromagnetic pulse shielding layer (2) on each surface (1) of a plurality of surfaces that form said construction, said installation comprising applying a coating (3) of an electrically insulative material on said surface and installing one or more layers (4, 6) of an electrically conductive mesh fabric upon said coating, said one or more layers of said fabric being separated by an embedding coating (5) of said electrically insulative material, and
- establishing an electrically conductive connection between the installed shielding layers (4,6) on adjoining surfaces of said construction, to form a continuous electrically conductive screen around said construction that is impenetrable for an electromagnetic pulse.

2. The method according to claim 1, wherein each layer (4, 6) of said fabric is installed by installing multiple runs of said fabric adjacently, and forming an electrically conductive seam (8) to couple adjacent runs of said fabric.

3. The method according to claim 2, wherein forming said electrically conductive seam (8) comprises:
- folding respective adjoining edges of said adjacent runs of the fabric,
- interlocking respective folds of said adjacent runs and clamping them at a predefined distance from said edges, and
- pressing said fabric to embed said fabric into the coating of said electrically insulative material and applying a further coating of said electrically insulative material over said seam.

4. The method according to any of the preceding claims, wherein said fabric comprises a copper mesh having a rectangular mesh size equal to or less than 0.4mm X 0.4mm.

5. The method according to any of the preceding claims wherein said electrically insulative material comprises bitumen or plaster.

6. The method according to any of the preceding claims, wherein said plurality of surfaces (1) are concrete surfaces including one or more surfaces on a foundation of said construction, one or more surfaces on walls below ground level, one or more surfaces on walls or ceilings above ground level and one or more surfaces on a roof of said construction.

7. The method according to claim any of claims 1 to 6, wherein the construction includes adjoining first and second surfaces, wherein said establishing of an electrically conductive connection between the installed shielding layers on said adjoining first and second surfaces comprises electrically conductively coupling said adjacently installed shielding layers using an anchor rail (9) fixed to said first surface.

8. The method according to claim 7, wherein said electrically conductive coupling using said anchor rail (9) further comprises:
- disposing a first metal plate (11) over said anchor rail (9) through one or more bolts (10) that are fixed to said anchor rail (9),
- carrying the layers (4, 6) of said electrically conductive mesh fabric on said first surface and said second surface over said one or more bolts (10) to form an overlap between said layers, said layers of the fabric being penetrated by the bolts (10),
- disposing a metallic spring (12) over said overlapping layers of fabric though said one or more bolts (10), and
- disposing a second metal plate (13) over said metallic spring (12) through said bolts (10).

9. The method according to any of claims 1 to 6, wherein said surface (1) has an anchor bolt (30) penetrated therethrough for installing a further mounting part of said construction thereto, said method further comprising permanently fastening a first washer (31) with an inner thread around said anchor bolt (30) before installing said shielding layer (2) on said surface and permanently fastening a second washer (32) with an inner thread around said anchor bolt (30) after said installation of said shielding layer (2), wherein said electrically conductive mesh fabric of said shielding layer (2) is penetrated by said anchor bolt (30) and said coatings (3, 5, 7) of said electrically insulative material are applied maintaining a clearance area (33) around said anchor bolt (30) corresponding to the surface of said washers (31, 32) .

10. The method according to claim 9, comprising:
- applying a first coating (3) of said electrically insulative material over said surface (1) after fastening said first washer (31) around said anchor bolt (30),
- installing a first layer (4) of the electrically conductive mesh fabric over said first coating (3), said fabric being penetrated by said anchor bolt (30),
- temporarily fastening the second washer (32) around said anchor bolt (30),
- applying a second coating (5) of said electrically insulative material over the first layer (4) of said fabric,
- removing the temporarily fastened second washer (31) and installing a second layer (6) of said fabric over said second coating (5), said second layer (6) of the fabric penetrated by said anchor bolt (30),
- applying a third coating (7) of said electrically insulative material over said second layer (6) of said fabric, said third coating maintaining a clearance area around said anchor bolt (30) corresponding to the surface of said washer (31), and
- permanently fastening said second washer (32) around said anchor bolt (30).

11. The method according to any of claims 1 to 6, further comprising:
- installing a roof gully (34) on said surface (1) by fixing a flanged base (35) of said roof gully (34) to said surface (1),
- installing said shielding layer (2) wherein the coatings (3, 5) of said electrically insulative material are applied over said surface (1) around said roof gully (34) and maintaining a predefined clearance from the area directly above the installation of said roof gully (34), and
- electrically conductively connecting said roof gully (34) to said shielding layer (2) using one or more layers of sealing wires (38, 39, 40, 41) disposed circumferentially around a circumferential row of bolts (36) fixed to said flanged base (34), the ends of each wire (38, 39, 40, 41) further being electrically conductively connected.

12. The method according to claim 11, further comprising:
- installing the roof gully (34) on said surface (1) after the application of a first coating (3) of said electrically insulative material on said surface (1),
- installing a first layer (4) of one or more of electrically conductive sealing wires (38, 39) supported circumferentially around said row of bolts (36),
- installing first and second layers (4, 6) of the electrically conductive mesh fabric upon said sealing wires (38, 39), said first and second layers (4, 6) of the fabric being penetrated by said bolts (36) and separated by said embedding coatings (3, 5) over said surface (1) around said roof gully (34) and interspaced by said sealing wires (38, 39) directly the installation of said roof gully (34),
- installing a second layer of one or more electrically conductive sealing wires (40, 41) over said second layer (6) of said mesh fabric and circumferentially supported around said bolts (36), and
- fastening an outer flange (43) to said bolts (36) over said second layer of sealing wires (40, 41).

13. The method according to any of claims 1 to 6, wherein the construction comprises first and second surfaces (1A, 1B) adjoining each other along an expandable joint (16), wherein the one or more layers (4, 6) of the electrically conductive mesh fabric are installed over said surfaces (1A, 1B) and also covering said joint (16) and the coatings (3, 5, 7) of said electrically insulative material are applied over said surfaces (1A, 1B) and maintaining a pre-defined clearance from said joint (16), the method further comprising installing one or more layers (17, 18) of an electrically insulative elastic membrane covering said joint (16) such that the one or more layers (4, 6) of said fabric are separated by said one or more layers (17, 18) of the elastic membrane over said joint (16).

14. The method according to claim 13, further comprising:
- installing a first layer (17) of the elastic membrane over said surfaces (1A, 1B) and covering said joint (16),
- applying a first coating (3) of said electrically insulative material over said surfaces (1A, 1B) and maintaining a predefined clearance from said joint (16) and installing a first layer (4) of the electrically conductive mesh fabric thereon and covering said joint (16),
- installing a second layer (18) of the elastic membrane upon the first layer (4) of said fabric and covering said joint (16), and
- applying a second coating (5) of said insulative material over said first layer (4) of said fabric maintaining a predefined clearance from said joint (16) and installing a second layer (6) of said fabric thereon and covering said joint (16).

15. The method according to any of claims 13 and 14, wherein installing each of the layers (17, 18) of the elastic membrane further comprises applying a coating of a bitumen primer and adhesively fixing said each layer (17, 18) of the elastic membrane the already applied primer.

16. The method according to claim 14, further comprising installing a layer of a polymer bitumen welding sheet (21) over said second layer (6) of said fabric over said surfaces (1A, 1B) and maintaining a predefined clearance from said joint (16), and further installing a layer (19) of an elastic water proofing membrane over said welding sheet (21) and covering said joint (16).

17. The method according to claim 16, further comprising installing one or more thermal insulation boards (25, 26, 27) over said elastic water proofing membrane.

18. The method according to any of claims 13 to 17, wherein said first and second surfaces (1A, 1B) are parallel to each other.

19. The method according to any of claims 13 to 17, wherein said first and second surfaces (1A, 1B) are perpendicular to each other.

20. The method according to any of claims 1 to 6, wherein said surface (1) has a pipe (50) penetrated therethrough, said method further comprising:
- installing said shielding layer (2) on said surface (1) around said pipe (50),
- disposing a metallic sleeve (51) around said pipe (50),
- disposing a metallic plate (53) on said surface(1) around said pipe (50), said metallic plate (53) being further welded to said metallic sleeve (51), and
- electrically conductively connecting said shielding layer (2) to said metallic plate (53).

21. A civil construction having an arrangement for protection of said construction from an electromagnetic pulse by installing a electromagnetic pulse shielding layer (2) on each surface (1) of a plurality of surfaces that form said construction and establishing an electrically conductive connection between the installed shielding layers (2) on adjoining surfaces of said construction, to form a continuous electrically conductive screen around said construction that is impenetrable for an electromagnetic pulse, in accordance with any of the preceding claims.
